(19) Europäisches Patentamt
European Patent Office
Office européen des brevets

(11) **EP 1 728 084 B1**

(12) **EUROPÄISCHE PATENTSCHRIFT**

(45) Veröffentlichungstag und Bekanntmachung des Hinweises auf die Patenterteilung:
**11.01.2012 Patentblatt 2012/02**

(21) Anmeldenummer: **05738728.4**

(22) Anmeldetag: **10.03.2005**

(51) Int Cl.:
*G01R 31/28* *(2006.01)*    *G01R 27/04* *(2006.01)*

(86) Internationale Anmeldenummer:
**PCT/DE2005/000429**

(87) Internationale Veröffentlichungsnummer:
**WO 2005/096005 (13.10.2005 Gazette 2005/41)**

(54) **MESS-SCHALTUNG FÜR DEN AUSGANG EINES LEISTUNGSVERSTÄRKERS SOWIE EIN DIE MESS-SCHALTUNG UMFASSENDER LEISTUNGSVERSTÄRKER**

MEASURING CIRCUIT FOR THE OUTPUT OF A POWER AMPLIFIER AND A POWER AMPLIFIER COMPRISING THE MEASURING CIRCUIT

CIRCUIT DE MESURE POUR LA SORTIE D'UN AMPLIFICATEUR DE PUISSANCE ET AMPLIFICATEUR DE PUISSANCE COMPORTANT UN CIRCUIT DE MESURE DE CE TYPE

(84) Benannte Vertragsstaaten:
**DE FR GB**

(30) Priorität: **25.03.2004 DE 102004014731**

(43) Veröffentlichungstag der Anmeldung:
**06.12.2006 Patentblatt 2006/49**

(73) Patentinhaber: **Infineon Technologies AG 85579 Neubiberg (DE)**

(72) Erfinder: **WAGNER, Elmar 47269 Duisburg (DE)**

(74) Vertreter: **Graf Lambsdorff, Matthias Patentanwälte Lambsdorff & Lange Dingolfinger Strasse 6 81673 München (DE)**

(56) Entgegenhaltungen:
WO-A-96/14665        US-A- 5 546 050
US-A1- 2002 118 034    US-B1- 6 424 191

EP 1 728 084 B1

**Beschreibung**

Die Erfindung betrifft eine Mess-Schaltung für einen Ausgang eines Verstärkers sowie ein die Mess-Schaltung umfassender Verstärker, insbesondere ein Hochfrequenz-Leistungsverstärker. Ferner betrifft die Erfindung einen die Mess-Schaltung umfassenden Regelkreis und ein Mess-Verfahren für einen Verstärkerausgang.

Häufig ist in Mobilfunksystemen vorgesehen, die Ausgangsleistung zu messen, um anhand der gemessenen Ausgangsleistung die Ausgangsleistung zu regeln. Insbesondere bei Mobilfunksystemen, welche ein Übertragungsverfahren mit variabler Amplitude nutzen, ist es im Allgemeinen notwendig, die Ausgangsleistung zu messen und zu regeln. Ein typisches Beispiel für ein Übertragungsverfahren mit variabler Amplitude stellt das sogenannte OFDM (Orthogonal Frequency Division Multiplexing) dar, welches insbesondere bei WLAN-Funksystemen nach dem IEEE-802.11a/h-Standard (Übertragungsfrequenz im Bereich von 5 GHz) oder 802.11g-Standard (Übertragungsfrequenz im Bereich von 2,4 GHz) zum Einsatz kommt. Hierbei wird das für die Funkübertragung zur Verfügung stehende Frequenzband in orthogonale Teilfrequenzbänder, beispielsweise 52 Teilfrequenzbänder, untergliedert, auf die der Datenverkehr einer Funkverbindung aufgeteilt wird. Dabei kann die Ausgangsleistung als Überlagerung der Leistung aller Teilfrequenzbänder aufgrund der Interferenz der Teilfrequenzbänder über einen weiten Dynamik-Bereich schwanken (ungefähr 17 dB). Aber auch bei Mobilfunksystemen nach dem EDGE- oder UMTS-Standard, welche eine höherwertige Phasenmodulation (PSK - Phase Shift Keying) verwenden, ist die Amplitude des Ausgangssignals variabel. Eine auf einer Leistungsmessung aufbauende Leistungsregelung ermöglicht es, dass die für den jeweiligen Betriebzustand optimale Ausgangsleistung vorliegt, ohne dass der die Sendeantenne treibende Leistungsverstärker übersteuert wird.

Die Ausgangsleistung wird im Allgemeinen auf Basis der Ausgangsspannung gemessen. Gewöhnlicherweise geschieht dies, indem der Spannungshub am Ausgang des die Sendeantenne treibenden Leistungsverstärkers gemessen wird. Nachteilig an der Messung auf Basis der Ausgangsspannung ist, dass die Ausgangsspannung von der Last des Leistungsverstärkers abhängt, wodurch die auf Basis der Ausgangsspannung gemessene Ausgangsleistung sich deutlich von der tatsächlich vorliegenden Leistung unterscheiden kann. Insbesondere für den Fall, dass die tatsächliche Last des Leistungsverstärkers, also die Antenne mit einem optionalen Anpassungs-Netzwerk, von der typischen Last beispielsweise durch Bauteilstreuung, Alterung oder Temperatureffekte abweicht, kann nicht allein anhand der Messung auf Basis der Ausgangsspannung auf die tatsächliche Ausgangsleistung geschlossen werden. In diesem Fall liegt eine ausgangsseitige Fehlanpassung vor.

Bei der Regelung der Ausgangsleistung auf Basis der Ausgangsspannung kann die Funktion des Leistungsverstärkers erheblich beeinträchtigt werden. Beispielsweise ist der Fall denkbar, dass die Lastimpedanz des Leistungsverstärkers geringer als der typische Wert ist. Liefert in diesem Fall der Ausgangsverstärker bereits den maximal möglichen Hub des Ausgangsstroms, ist der tatsächliche Hub der Ausgangsspannung dennoch geringer als der maximal mögliche Hub der Ausgangsspannung, der seitens der Leistungsregelung angestrebt werden sollte. Die Leistungsregelung reagiert auf die gemessene Leistungsinformation basierend auf der Ausgangsspannung derart, dass diese versucht, den Hub des Ausgangsstroms zu erhöhen. Dies bewirkt, dass die Ausgangsstufe des Leistungsverstärkers in die Begrenzung getrieben wird, so dass durch den nichtlinearen Betrieb der Ausgangsstufe das Ausgangssignal verzerrt wird. Die Leistungsregelung treibt in diesem Fall den Leistungsverstärker also in den begrenzenden Betrieb. Ist umgekehrt die Lastimpedanz des Leistungsverstärkers höher als der typische Wert, führt die Fehlinterpretation der auf Basis der Ausgangsspannung gemessenen Leistungsinformation seitens der Leistungsregelung dazu, dass die geregelte Ausgangsleistung zu gering ist. Die Gefahr für eine Leistungsregelung, welche lediglich auf der Messung der Ausgangsspannung basiert, ist daher, dass entweder die geregelte Ausgangsleistung zu gering ist oder der Ausgangsverstärker durch die Regelung in der Begrenzung betrieben wird.

Die vorstehend beschriebene Problematik kann umgangen werden, indem ein externer Richtkoppler zwischen dem Leistungsverstärker und der Antenne vorgesehen wird. Ein derartiger Richtkoppler verfügt über zwei Messausgänge, wobei die Ausgangsspannung eines Hochfrequenz-Detektors an dem ersten Messausgang proportional zu der an die Antenne transmittierten Leistung und die Ausgangsspannung eines Hochfrequenz-Detektors an dem zweiten Messausgang proportional zu der von der Antenne reflektierten Leistung ist. Aus der Differenz beider Größen lässt sich die seitens der Antenne abgestrahlte Leistung bestimmen. Nachteilig an einer derartigen Lösung ist, dass zusätzliche Komponenten wie ein externer Richtkoppler und ein oder zwei Hochfrequenz-Detektoren notwendig sind. Dies verursacht zusätzliche Kosten und eine Vergrößerung des Senders.

US 2002/0118034 A1 offenbart ein Verfahren zum Überprüfen von Transistorvorrichtungen unter Verwendung einer virtuellen Abschlussvorrichtung.

WO 96/14665 offenbart ein Verfahren, bei dem die Ermitter-Last eines Transistors auf der Basis einer Kopie des Laststroms überwacht wird.

US 5,546,050 offenbart ein Pulsnivellierungssystem zum automatischen Überwachen der Amplitude eines Vorfrequenzsignals auf dem Bus.

US 6,424,191 B1 offenbart einen Stromsenken-Schaltkreis mit reduzierten Leckeffekten.

Es ist daher Aufgabe der Erfindung, eine Mess-Schaltung für einen Verstärker anzugeben, deren Ausgangsgröße zur Regelung des Verstärkers, insbesondere zur Regelung der Ausgangsleistung des Verstärkers, mit dem Ziel eines optimalen Betriebspunkts der Ausgangsstufe des Verstärkers dienen kann. Dabei sollte die Mess-Schaltung kosten- und aufwandsminimal implementierbar sein. Außerdem ist es Aufgabe der Erfindung, ein entsprechendes Verfahren anzugeben. Darüber hinaus ist die Erfindung auf die Angabe eines eine derartige Mess-Schaltung umfassenden Verstärkers, insbesondere Hochfrequenz-Leistungsverstärkers, und eines entsprechenden Regelkreises gerichtet.

Die Aufgabe wird durch die unabhängigen Patentansprüche gelöst.

Die erfindungsgemäße Mess-Schaltung für einen Ausgang eines Verstärkers gemäß Anspruch 1 umfasst einen ersten Transistor. Dabei ist der Ausgangsstrom des ersten Transistors charakteristisch für den Ausgangsstrom des Verstärkers, insbesondere ist dieser im wesentlichen proportional zum Ausgangsstrom des Verstärkers. Der erste Transistor wird parallel zu mindestens einem den Verstärkerausgang treibenden zweiten Transistor angesteuert.

Typischerweise werden statt eines einzigen zweiten Transistors eine Vielzahl parallelgeschalteter zweiter Transistoren verwendet. Im Hinblick auf die parallele Ansteuerung ist es zwar von Vorteil, aber nicht zwingend erforderlich, dass die angesteuerten Anschlüsse des ersten und des mindestens einen zweiten Transistors direkt kurzgeschlossen sind. Eine parallele Ansteuerung kann im Sinne der Anmeldung auch dann vorliegen, wenn zwischen den Anschlüssen des ersten und des mindestens einen zweiten Transistors ein Netzwerk angeordnet ist. Beispielsweise wäre es denkbar, dass der erste Transistor und der mindestens eine zweite Transistor jeweils von einem Emitterfolger angesteuert werden, wobei beide Emitterfolger mit dem gleichen Signal angesteuert werden.

Das von der erfindungsgemäßen Mess-Schaltung bereitgestellte Stromsignal des mindestens einen zweiten Transistors ermöglicht eine indirekte Strommessung des Ausgangsstroms des Verstärkers. Im Sinne der Erfindung kann das von der Mess-Schaltung bereitgestellte Stromsignal vielfältig zur Regelung des Verstärkers eingesetzt werden. Anhand des Stromsignals kann direkt abgelesen werden, ob der zweite Transistor im linearen Betrieb arbeitet oder bereits übersteuert wird. Diese Information kann bei der Regelung der Ausgangsleistung berücksichtigt werden. Ferner können durch eine Verknüpfung des gemessenen Stromsignals und der zusätzlich gemessenen Ausgangsspannung ein oder mehrere davon abhängige Größen zur Leistungsregelung bestimmt werden. Insbesondere kann durch Multiplikation des Ausgangsstroms und der Ausgangsspannung die Ausgangsleistung bestimmt werden.

Die Mess-Schaltung erfordert nur einen geringen zusätzlichen Schaltungsaufwand, insbesondere lässt sich diese zusammen mit dem Verstärker in einer monolithisch-integrierten Schaltung implementieren. Darüber hinaus wird durch den Einsatz der Mess-Schaltung die Funktion des mindestens einen zweiten Transistors nicht beeinträchtigt; der maximal mögliche Ausgangshub wird durch den Einsatz der Mess-Schaltung nicht reduziert. Demgegenüber wird bei einer nicht erfindungsgemäßen Messung des Ausgangsstroms über zusätzliche Widerstände, welche in Serie zu einem den Ausgangsstrom führenden Anschluss (beispielsweise in Serie zum Emitter- oder Kollektor-Anschluss bei einer Emitter-Schaltung) des mindestens einen zweiten Transistors geschaltet sind, der maximal mögliche Ausgangshub des mindestens einen zweiten Transistors reduziert.

Es ist von Vorteil, wenn der erste Transistor der Mess-Schaltung und der mindestens eine den Verstärkerausgang treibende zweite Transistor in einer Emitter- bzw. Source-Schaltung betrieben werden. Dabei ist es von Vorteil, wenn der Basis-Anschluss bzw. der Gate-Anschluss sowie der Emitter-Anschluss bzw. Source-Anschluss des ersten Transistors mit dem jeweils entsprechenden Anschluss des den Verstärkerausgang treibenden mindestens einen zweiten Transistors kurzgeschlossen sind.

Die vorstehend beschriebene Parallelschaltung ermöglicht es, dass jeweils die Basis-Emitter-Spannung (Implementierung mit Bipolar-Transistoren) bzw. die Gate-Source-Spannung (Implementierung mit MOS-Transistoren) des ersten Transistors und des mindestens einen zweiten Transistors einander entsprechen. Wird vorteilhafterweise darüber hinaus gefordert, dass der erste Transistor vom selben Typ wie der mindestens eine den Verstärkerausgang treibende zweite Transistor ist, ist der Ausgangsstrom des ersten Transistors näherungsweise proportional zum Ausgangsstrom des mindestens einen zweiten Transistors. Gemäß der Funktionsweise eines sogenannten Stromspiegels gilt für diesen Fall, dass das Verhältnis des Ausgangsstroms des ersten Transistors zum Ausgangsstrom des mindestens einen den Verstärkerausgang treibenden zweiten Transistors dem Flächenverhältnis der beiden vorstehend genannten Transistoren entspricht. Bei einer gemeinsamen monolithischen Integration des Verstärkers und der Mess-Schaltung wirken sich eine Bauteilstreuung, eine Alterung oder Temperatureffekte auf beide Transistoren in gleichem Maße aus, so dass der Proportionalitätsfaktor zwischen dem Ausgangsstrom des ersten Transistors und dem Ausgangsstrom des mindestens einen zweiten Transistors konstant bleibt. Dies wird auch als "Transistor-Matching" bezeichnet.

Vorteilhafterweise umfasst die Mess-Schaltung einen Widerstand, der den Ausgangsstrom des ersten Transistors in ein elektrisches Spannungssignal wandelt. Dabei ist es von Vorteil, wenn der Wert des Widerstands geringer, insbesondere wesentlich geringer, als die Ausgangsimpedanz des ersten Transistors ist. Dies bietet den Vorteil, dass die Größe des Stroms, welcher durch die Ausgangsimpedanz des ersten Transistors fließt, gering ist. In diesem Fall ist der Ausgangsstrom des ersten Transistors und auch das elektrische Spannungssignal am Widerstand proportional zum Kurzschluss-Strom des mindestens einen zweiten Transistors.

Es ist von Vorteil, wenn die Mess-Schaltung ein Mittel zur Bereitstellung einer Größe umfasst, welche für die Funktion des mindestens einen den Verstärkerausgang treibenden zweiten Transistors charakteristisch ist. Das Mittel bestimmt die Größe in Abhängigkeit des Ausgangsstroms des ersten Transistors oder einer von dem Ausgangsstrom des ersten Transistors abhängigen Spannung. Die für die Funktion charakteristische Größe betrifft die ausgangsseitige Anpassung des Verstärkers und/oder die Ausgangsleistung des Verstärkers. Alternativ oder zusätzlich kann diese auch die Aussteuerung des den Verstärkerausgang treibenden mindestens einen zweiten Transistors betreffen. Vorzugsweise, aber nicht zwingend, kann die für die Funktion charakteristische Größe zusätzlich auch von der Ausgangsspannung des Verstärkers abhängig sein.

Eine für die Funktion des mindestens einen den Verstärkerausgang treibenden zweiten Transistors charakteristische Größe ist im Sinne der Anmeldung eine Größe, welche angibt, wie der mindestens eine zweite Transistor in Bezug auf seine Funktion, insbesondere in Bezug auf die Leistungsverstärkung, in der Verstärkerschaltung betrieben wird. Eine für die Funktion charakteristische Größe kann beispielsweise eine für die Anpassung oder Fehlanpassung charakteristische Größe sein. Liegt eine Fehlanpassung vor, hat dies Einfluss auf die Leistungsverstärkung des mindestens einen zweiten Transistors. Bei einer Fehlanpassung ist die Ausgangsleistung geringer als die maximal mögliche Leistung bei einer Leistungsanpassung. Eine für die Funktion charakteristische Größe kann aber auch eine für die Ausgangsleistung charakteristische Größe sein, die in direkter Weise zur Regelung der Ausgangsleistung herangezogen werden kann. Eine für die Funktion charakteristische Größe kann ferner auch in einer Angabe zur Aussteuerung des mindestens einen zweiten Transistors liegen. Liegt eine Übersteuerung des mindestens einen zweiten Transistors vor, wird die Ausgangsspannung verzerrt, so dass die Funktion des mindestens einen zweiten Transistors, nämlich eine möglichst lineare Leistungsverstärkung, nicht mehr gegeben ist.

Vorteilhafterweise umfasst die Mess-Schaltung ein Mittel, insbesondere einen Hochfrequenz-Detektor, zur Bereitstellung einer für die Ausgangsspannung des Verstärkers charakteristischen elektrischen Größe. Dieses Mittel umfasst im einfachsten Fall lediglich einen Abgriff der Ausgangsspannung. Dieser kann über einen zusätzlichen Widerstand hochohmig ausgeführt werden, so dass der Einfluss des Abgriffs auf den Ausgang des Verstärkers vernachlässigbar ist. Bei der Verwendung eines Hochfrequenz-Detektors wird in Abhängigkeit der Ausgangsspannung des Verstärkers im Allgemeinen ein gemitteltes Ausgangssignal gebildet. Dieses enthält dann jedoch keine Phaseninformation mehr.

Nach einer vorteilhaften Ausführungsform umfasst die Mess-Schaltung ein Mittel zur Bereitstellung einer für die Ausgangsleistung charakteristischen Größe. Dabei bestimmt das Mittel die Größe in Abhängigkeit des Ausgangsstroms des ersten Transistors oder einer von diesem Ausgangsstrom abhängigen elektrischen Spannung. Ferner wird zur Bestimmung der für die Ausgangsleistung charakteristischen Größe die für die Ausgangsspannung des Verstärkers charakteristische elektrische Größe herangezogen. Vorzugsweise führt das Mittel zur Bestimmung einer für die Ausgangsleistung charakteristischen Größe eine Multiplikation durch. Es ist von Vorteil, wenn die Mess-Schaltung zu diesem Zweck einen Mischer umfasst. Das Ausgangssignal des Mischers weist eine Gleichstrom-Komponente und eine Wechselstrom-Komponente bei der doppelten Frequenz der Ausgangsspannung auf. Die Wechselstrom-Komponente kann durch ein zusätzliches Tiefpass-Filter unterdrückt werden. Die Gleichstrom-Komponente des Ausgangssignals des Mischers ist proportional zur Ausgangsleistung des Verstärkers.

Nach einer alternativen Ausführungsform umfasst die Mess-Schaltung ein Mittel zur Bereitstellung einer für die Impedanz am Verstärkerausgang charakteristischen Größe. Das Mittel ermittelt die Größe in Abhängigkeit der für die Ausgangsspannung des Verstärkers charakteristischen elektrischen Größe und des Ausgangsstroms des ersten Transistors. Statt des Ausgangsstroms kann auch eine von diesem Ausgangsstrom abhängige elektrische Spannung als Eingangsgröße des vorstehend genannten Mittels herangezogen werden. Vorteilhafterweise wird die für die Impedanz charakteristische Größe durch Division ermittelt. Je nach Wahl des Zählers und des Nenners ergibt sich als Ausgangsgröße eine Impedanz oder eine Admittanz. Anhand der Ausgangsgröße lässt sich feststellen, ob eine Fehlanpassung vorliegt oder nicht.

Nach einer alternativen Ausführungsform umfasst die Mess-Schaltung ein Mittel zur Bereitstellung einer für das Stehwellenverhältnis oder für den Reflektionsfaktor charakteristischen Größe. Dabei bestimmt das Mittel die Größe in Abhängigkeit des Ausgangsstroms des ersten Transistors oder einer von diesem Ausgangsstrom abhängigen elektrischen Spannung. Ferner wird zur Bestimmung der für die Ausgangsleistung charakteristischen Größe die für die Ausgangsspannung des Verstärkers charakteristische elektrische Größe herangezogen.

Nach einer weiteren alternativen Ausführungsform umfasst die Mess-Schaltung ein Mittel zur Bereitstellung einer für die Phasendifferenz zwischen dem Ausgangsstrom des ersten Transistors und der für die Ausgangsspannung des Verstärkers charakteristischen elektrischen Größe. Bei diesem Mittel handelt es sich vorzugsweise um einen Phasenkomparator. Mit Hilfe des Ausgangssignals des Phasenkomparators kann festgestellt werden, ob der Ausgang des Verstärkers bei der Betriebsfrequenz (z. B. 2,4 GHz) des Verstärkers angepasst ist oder nicht. Sind der Ausgangsstrom und die Ausgangsspannung nicht gegenphasig, liegt bei der betrachteten Frequenz eine induktive oder kapazitive Fehlanpassung vor.

Vorteilhafterweise umfasst die Mess-Schaltung ein Mittel, welches in Abhängigkeit der für die Ausgangsspannung des Verstärkers charakteristischen elektrischen Größe angibt, ob der mindestens eine den Verstärkerausgang treibende zweite Transistor übersteuert wird. Dies kann durch einen Vergleich der für die Ausgangsspannung charakteristischen Größe mit der Sättigungsspannung des zweiten Transistors geschehen. Ist die Spannung am Ausgang des Verstärkers, d. h. am Kollektor- bzw. Drain-Anschluss des mindestens einen zweiten Transistors, geringer als die Sättigungsspannung des mindestens einen zweiten Transistors wird der mindestens eine zweite Transistor übersteuert. In diesem Fall sollte das ansteuernde Signal in seiner Amplitude reduziert werden.

Der erfindungsgemäße Verstärker gemäß Anspruch 14 umfasst eine erfindungsgemäße Mess-Schaltung sowie mindestens einen den Verstärkerausgang treibenden zweiten Transistor. Bei dem Verstärkerausgang handelt es sich insbesondere um einen Open-Collector- bzw. Open-Drain-Verstärkerausgang. Ein derartiger Ausgang kennzeichnet sich dadurch, dass dieser Chip-intern keinen Anschluss an die Versorgungsspannung aufweist. Der Kollektor- bzw. Drain-Anschluss des mindestens einen den Verstärkerausgang treibenden zweiten Transistors läuft ohne Anschluss einer Verstärkerlast leer. Es ist jedoch auch möglich das Anpassnetzwerk in den Chip zu integrieren, wobei dann eine Verbindung zur Versorgungsspannung entsteht. Vorzugsweise handelt es sich bei dem Verstärker um einen Hochfrequenz-Verstärker, insbesondere um einen Hochfrequenz-Leistungsverstärker.

Der erfindungsgemäße Regelkreis gemäß Anspruch 16 dient der Regelung einer mit einer erfindungsgemäßen Mess-Schaltung bestimmten Größe eines erfindungsgemäßen Verstärkers. Der Regelkreis umfasst dabei eine erfindungsgemäße Mess-Schaltung. Vorzugsweise dient der Regelkreis der Regelung der Ausgangsleistung, wobei eine für die Ausgangsleistung des Verstärkers charakteristische Größe von der Mess-Schaltung bestimmt wird und durch den Regelkreis auf den optimalen Wert geregelt wird.

Bei dem erfindungsgemäßen Mess-Verfahren für einen Ausgang eines Verstärkers gemäß Anspruch 17 wird der Ausgangsstrom eines ersten Transistors ermittelt. Dabei wird der erste Transistor parallel zu mindestens einem den Verstärkerausgang treibenden zweiten Transistor angesteuert. Der Ausgangsstrom ist charakteristisch für den Ausgangsstrom des Verstärkers, insbesondere im wesentlichen proportional zum Ausgangsstrom des Verstärkers.

Die Erfindung wird nachfolgend anhand mehrerer Ausführungsbeispiele unter Bezugnahme auf die Zeichnungen näher erläutert; in diesen zeigen:

Fig. 1    eine Beschaltung eines Leistungsverstärkers zur Angabe der Ausgangsleistung nach dem Stand der Technik; und

Fig. 2    eine erfindungsgemäße Beschaltung eines erfindungsgemäßen Leistungsverstärkers zur Bestimmung des Ausgangsstroms und der Ausgangsleistung.

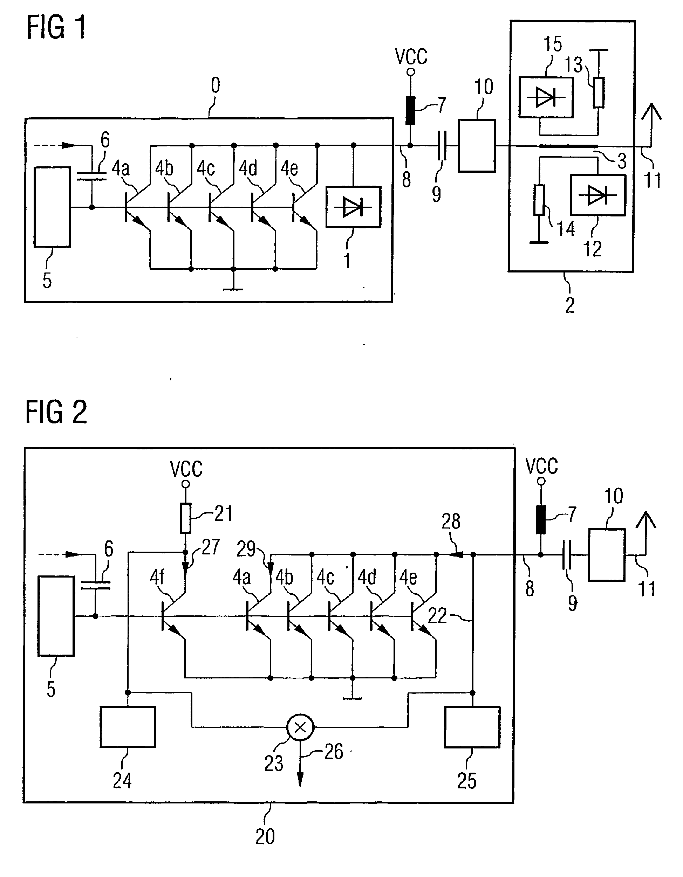

In Fig. 1 sind zwei alternative Möglichkeiten zur Beschaltung eines monolithisch-integrierten Hochfrequenz-Leistungsverstärkers 0 dargestellt, welche beide die Messung der Ausgangsleistung nach dem Stand der Technik betreffen. Gemäß der ersten Alternative wird ein Hochfrequenz-Detektor 1 verwendet, welcher die Ausgangsleistung indirekt über die Ausgangsspannung bestimmt. Alternativ kann ein Chip-externes Netzwerk 2 zur Angabe der Ausgangsleistung verwendet werden, wobei dieses Netzwerk einen Richtkoppler 3 umfasst.

Der Hochfrequenz-Leistungsverstärker 0 wird dabei in einem Mobilfunk-System eingesetzt, beispielsweise in einer WLAN-Sendeeinrichtung für Trägerfrequenz-modulierte Signale im Frequenzbereich zwischen 2,4 GHz und 2,5 GHz oder alternativ für den Frequenzbereich zwischen 5,15 GHz und 5,825 GHz. Die Ausgangsstufe des Leistungsverstärkers 0 umfasst einen oder mehrere parallel geschaltete npn-Bipolar-Transistoren 4a-4e, welche den Ausgang 8 des Leistungsverstärkers 0 treiben. Die Ausgangsstufe des Leistungsverstärkers 0 bildet eine Emitter-Schaltung. Wird in der Ausgangsstufe lediglich ein Einzeltransistor verwendet, weist dieser eine sehr große aktive Transistorfläche (Emitterfläche) auf. Werden, wie hier dargestellt, mehrere parallel geschaltete Transistoren 4a-4e verwendet, kann die Emitterfläche der Transistoren 4a-4e entsprechend verringert werden. Die Einstellung des Arbeitspunktes erfolgt Basis-seitig über ein nicht näher dargestelltes Netzwerk 5, welches das Basis-Potential festlegt. Das Hochfrequenz-Eingangssignal der Ausgangsstufe wird von einer der Ausgangsstufe vorgeschalteten Verstärkerstufe (nicht dargestellt) geliefert, wobei die beiden Verstärkerstufen für Hochfrequenz-Signale über die Kapazität 6 gekoppelt sind (auch als sogenannte AC-Kopplung bezeichnet). Die Emitter-Anschlüsse der Transistoren 4a-4e sind mit dem MassePotential verbunden.

Bei dem Verstärkerausgang 8 handelt es sich um einen Open-Collector-Ausgang, d. h. ein Chip-interner Abschluss des Ausgangs 8 ist nicht vorgesehen. Über eine Induktivität 7 wird die positive Betriebsspannung VCC (z. B. + 3,3 V) den Kollektoren der Transistoren 4a-4e zugeführt. Der Gleichanteil des Kollektorstroms der Transistoren 4a-4e fließt über die Induktivität 7. Die Induktivität 7 kann wie die übrigen ausgangsseitigen passiven Bauelemente Chip-extern (wie in Fig. 1 dargestellt) oder alternativ Chip-intern realisiert werden. Dabei weisen Chip-externe Bauelemente im Vergleich zu Chipinternen Bauelementen im Allgemeinen eine höhere Güte auf, wobei bei der Verwendung Chip-externer Bauelemente die Kosten durch eine damit einhergehend aufwändigere Leiterplattenfertigung zunehmen. Der Verstärkerausgang 8 und die Last des Verstärkers sind über eine Chip-externe Kapazität 9 ACgekoppelt, d. h. die Kapazität 9 bildet einen Hochfrequenz-Kurzschluss. Zwischen der eigentlichen Last des Leistungsverstärkers, nämlich der Antenne 11, und der Kapazität 9 ist ein Anpassungs-Netzwerk 10 geschaltet. Dieses führt eine Transformation der Impedanz der Antenne 11 durch. Das Anpassungs-Netzwerk wird dabei so gewählt, dass am Ausgang 8 eine Leistungsanpassung vorliegt, d. h. dass die Quellenimpedanz der konjugiert-komplexen Lastimpedanz am Ausgang 8 entspricht. Zwischen der Antenne 11 und dem Anpassungs-Netzwerk 10 befindet sich im Allgemeinen eine Leitung (nicht dargestellt), wobei zwecks Anpassung die Leitungsimpedanz der Impedanz der Antenne 11 entspricht.

Gemäß der ersten aus dem Stand der Technik bekannten Alternative zur Bestimmung der Ausgangsleistung wird die Ausgangsleistung am Verstärkerausgang 8 durch einen Hochfrequenz-Detektor 1 gemessen. Der Hochfrequenz-Detektor 1 umfasst eine Diode und erzeugt durch Dioden-Gleichrichtung eine Gleichspannung oder einen Gleichstrom, wobei die Gleichspannung bzw. der Gleichstrom proportional zur Amplitude der Ausgangsspannung ist. Dabei ist das Quadrat der Amplitude der Ausgangsspannung proportional zur Hochfrequenz-Ausgangsleistung. Nachteilig an dieser Realisierung der Leistungsmessung ist, dass von der Ausgangsgröße des Detektors 1 nicht auf die tatsächliche Ausgangsleistung geschlossen werden kann, falls die tatsächliche Last von der typischen Last des Leistungsverstärkers 0 abweicht.

Es ist ferner aus dem Stand der Technik bekannt, zur Leistungsmessung alternativ, wie in Fig. 1 dargestellt, ein Chip-externes Netzwerk 2 vor die Antenne 11 zu schalten, welches einen Richtkoppler 3 umfasst. Der Richtkoppler 3 wird mit Hochfrequenz-Detektoren 15 und 12 sowie Abschluss-Widerständen 13 und 14 beschaltet. Der Hochfrequenz-Detektor 15 liefert eine Ausgangsgröße, welche proportional zur Wurzel der an die Antenne 11 transmittierten Leistung, und der Hochfrequenz-Detektor 12 liefert eine Ausgangsgröße, welche proportional zur Wurzel der seitens der Antenne 11 reflektierten Leistung ist. Aus diesen beiden Größen kann die tatsächlich abgestrahlte Leistung bestimmt werden. Nachteilig an einer derartigen Lösung ist, dass zusätzliche externe Komponenten notwendig sind.

In Fig. 2 ist die erfindungsgemäße Beschaltung eines monolithisch-integrierten Hochfrequenz-Leistungsverstärkers 20 dargestellt. Mit gleichen Bezugszeichen versehene Figurenbestandteile aus Fig. 1 und Fig. 2 entsprechen einander. Im Unterschied zu Fig. 1 ist ein weiterer Transistor 4f Basis- und Emitter-seitig parallel zu den Transistoren 4a-4e geschaltet. Dabei entspricht der Transistor-Typ des Transistors 4f demjenigen der Transistoren 4a-4e. Im vorliegenden Fall weist der Transistor 4f die gleiche Größe wie einer der Transistoren 4a-4e auf. Der Kollektor des Transistors 4f ist dabei nicht mit dem Ausgang 8 des Leistungsverstärkers, sondern mit einem Widerstand 21 verbunden. Der zweite Anschluss des Widerstands 21 ist mit der Betriebsspannung VCC verbunden, so dass der Widerstand 21 den Lastwiderstand des in Emitter-Schaltung betriebenen Transistors 4f bildet. Ferner ist vorgesehen, die Spannung am Ausgang des Verstärkers über einen Abgriff 22 verfügbar zu machen. Die über den Abgriff 22 bereitgestellte Ausgangsspannung sowie die an dem Widerstand 21 abfallende Spannung werden einem Mischer zugeführt. Hochfrequente Signalanteile im Ausgangssignal 26 des Mischers können durch ein zusätzliches, dem Mischer nachgeschaltetes Tiefpass-Filter (nicht dargestellt) unterdrückt werden. Ferner können optional zusätzliche Schaltungsblöcke 24 und 25 vorgesehen werden, wobei der Schaltungsblock 24 das an dem Widerstand 21 abfallende Spannungssignal und der Schaltungsblock 25 das am Ausgang 8 auftretende Spannungssignal auswerten.

Da die Ansteuerung des Transistors 4f - wie bei einem Stromspiegel - der der Transistoren 4a-4e entspricht, gilt näherungsweise, dass der Strom 27 proportional zum Ausgangsstrom 28 der Transistoren 4a-4e ist. Insbesondere gilt, dass der Ausgangsstrom 27 des Transistors 4f dem Ausgangsstrom 29 eines der Transistoren 4a-4e näherungsweise entspricht, wenn beide vom gleichen Typ sind. Damit ist die Spannung am Widerstand 21 näherungsweise proportional zum Ausgangsstrom 28 des Leistungsverstärkers 20. Werden die Gleichstromkomponenten der Spannungssignale am Ausgang 8 und am Widerstand 21 nicht berücksichtigt (beispielsweise durch eine nicht dargestellte AC-Kopplung vor den Mischer-Eingängen) ist das Produkt dieser Spannungssignale näherungsweise proportional zu der in der Last des Leistungsverstärkers verbrauchten Wirkleistung, d. h. näherungsweise zu der Leistung, welche die Antenne 11 abstrahlt. Wird der Wechselanteil des Spannungssignals am Ausgang 8 durch

$$u_1 = a \cdot \cos(\varpi t + \alpha) \tag{1}$$

und der Wechselanteil des Spannungssignals am Widerstand 21 durch

$$u_2 = b \cdot \cos(\varpi t + \beta) \tag{2}$$

beschrieben, so ist das Ausgangssignal des Mischers 23 im linearen Aussteuerbereich des Mischers proportional zu

$$u_1 \cdot u_2 = [a \cdot \cos(\varpi t + \alpha)] \cdot [b \cdot \cos(\varpi t + \beta)] = \\ a \cdot b \cdot \cos(\alpha - \beta) + a \cdot b \cdot \cos(2\varpi t + \alpha + \beta) \tag{3}$$

Das Ausgangssignal 26 des Mischers weist gemäß Glg. 3 eine Gleichstrom-Komponente und eine Wechselstrom-Komponente bei der doppelten Frequenz der Ausgangsspannung auf. Die Wechselstrom-Komponente kann durch ein zusätzliches Tiefpass-Filter unterdrückt werden. Die Gleichstrom-Komponente des Ausgangssignals 26 des Mischers ist dann proportional zu derjenigen Leistung, welche in der Last des Verstärkers 20 verbraucht wird. Dabei ist ersichtlich, dass der für die Leistung ermittelte Messwert sowohl von den Amplituden a, b der Spannungssignale $u_1$, $u_2$ als auch von der Phasendifferenz α - β der Spannungssignale $u_1$, $u_2$ abhängig ist. Dabei gilt, dass die Phasendifferenz dann null ist, wenn der Ausgang des Leistungsverstärkers angepasst ist. Liegt eine kapazitive oder induktive Fehlanpassung vor, ist die Phasendifferenz von null verschieden. In diesem Fall wird ein Teil der zur Antenne 11 transmittierten Leistung reflektiert und nicht in der Antenne 11 absorbiert. Da das Ausgangssignal von der Phasendifferenz abhängig ist, arbeitet der Mischer gleichzeitig auch als Phasenkomparator.

Die in der Antenne verbrauchte Wirkleistung stellt dann die maximal mögliche Wirkleistung dar, wenn die Spannungssignale $u_1$, $u_2$ in Phase sind (bzw. der Strom des Transistors 4f und die Spannung am Ausgang 8 gegenphasig sind) und der Spannungshub am Ausgang 8 des Leistungsverstärkers 20 den maximal zulässigen Wert hat sowie der Strom durch die Transistoren maximal ist. Wird der am Ausgang 8 des Leistungsverstärkers 20 maximal zulässige Wert des Spannungshubs überschritten, arbeitet die Ausgangsstufe des Leistungsverstärkers 20 stark nicht-linear. Das Ausgangssignal wird aufgrund der Limitierung auf die Betriebsspannung (maximal) und die Sättigungsspannung (minimal) quasi abgeschnitten. Dies wird auch als "Clipping" bezeichnet. Ist der Spannungshub am Ausgang des Leistungsverstärkers geringer als der maximal zulässige, wird nicht die maximal mögliche Leistung in der Antenne 11 absorbiert. Dies ist dann der Fall, wenn die Impedanz am Ausgang 8 des Verstärkers 20 zu niedrig ist. Wird hingegen der maximal zulässige Spannungshub am Ausgang 8 des Verstärkers 20 überschritten, ist die Impedanz am Ausgang 8 des Verstärkers 20 zu hoch. Sind die Spannungssignale $u_1$, $u_2$ hingegen nicht gleichphasig, liegt eine kapazitive oder induktive Fehlanpassung vor.

Zur Maximierung der in der Antenne 11 absorbierten Leistung ohne Übersteuerung der Ausgangsstufe des Leistungsverstärkers 20 sollten daher im Regelkreis zur Leistungsregelung mehrere Größen überwacht werden: einerseits die Phasendifferenz bzw. die absorbierte Leistung, welche sich aus dem Ausgangssignal des Mischers ergibt und andererseits der Spannungshub am Ausgang 8 des Verstärkers 20. Zur Überwachung des Spannungshubs am Ausgang 8 kann der Schaltungsblock 25 als Hochfrequenz-Detektor ausgeführt werden. Alternativ kann der Schaltungsblock 25 derart ausgestaltet sein, dass dieser die Spannung am Ausgang 8 des Verstärkers 20 mit der Sättigungsspannung (typischerweise je nach Transistor-Typ und Temperatur im Bereich von 100 mV bis 400 mV) zwischen Kollektor und Emitter der Transistoren 4a-4e vergleicht. Ist die niedrigste am Ausgang 8 auftretende Spannung genauso groß oder kleiner als die Sättigungsspannung, wird die Ausgangsstufe des Leistungsverstärkers 20 übersteuert. In diesem Fall muss die Amplitude der Spannung am Ausgang 8 reduziert werden.

Die in Fig. 2 dargestellte Schaltung lässt sich im Sinne der Erfindung auch dahingehend modifizieren, dass andere für die Funktion der Transistoren 4a-4e charakteristische Größen bestimmt werden. Insbesondere kann statt des Mischers 23 ein Schaltungsblock vorgesehen werden, welcher die Impedanz am Ausgang des Verstärkers 20 misst. Werden in einem derartigen Schaltungsblock die Zeiger des Wechselanteils der Spannung am Ausgang 8 und der Spannung an dem Widerstand 21 dividiert, ergibt sich eine zur Impedanz am Ausgang 8 des Verstärkers proportionale Größe.

In ähnlicher Weise können weitere Größen wie beispielsweise das Stehwellenverhältnis oder der Reflektionsfaktor am Ausgang des Verstärkers bestimmt werden, indem die Wechselanteile der Spannungssignale am Ausgang des Widerstands 21 und am Ausgang 8 in der der Berechnungsvorschrift dieser Größen entsprechenden Weise ausgewertet werden. Das Stehwellenverhältnis ergibt sich als Verhältnis der am Ausgang 8 wirksamen Impedanz zur Impedanz der Ausgangsleitung (z. B. 50 Ohm) bzw. zur transformierten Impedanz der Ausgangsleitung bei Verwendung eines Anpassungs-Netzwerkes 10. Insofern kann bei Kenntnis der Impedanz des Ausgangs 8 (wie vorstehend bereits beschrieben) leicht das Stehwellenverhältnis ermittelt werden.

In Bezug auf die vorstehenden Aussagen ist anzumerken, dass statt der Spannung am Widerstand 21 in analoger Weise auch direkt das Stromsignal 27 verwendet werden kann.

## Patentansprüche

1. Mess-Schaltung für einen Ausgang (8) eines Verstärkers (20), mit:

   - einem ersten Transistor (4f), dessen Ausgangsstrom (27) charakteristisch für den Ausgangsstrom (28) des Verstärkers (20) ist, insbesondere im wesentlichen proportional zum Ausgangsstrom (28) des Verstärkers (20), und welcher parallel zu mindestens einem den Verstärkerausgang (8) treibenden zweiten Transistor (4a-4e) angesteuert wird, und
   - einem Mittel zur Bereitstellung einer für die Ausgangsleistung des Verstärkers charakteristischen Größe (26),

wobei das Mittel (23) die für die Ausgangsleistung des Verstärkers charakteristische Größe durch eine Multiplikation des Ausgangsstroms (27) des ersten Transistors (4f) oder einer von diesem Ausgangsstrom (27) abhängigen elektrischen Spannung und einer für die Ausgangsspannung des Verstärkers (20) charakteristischen elektrischen Größe bestimmet.

2. Mess-Schaltung nach Anspruch 1,
**dadurch gekennzeichnet,**
**dass**

- der erste Transistor (4f) der Mess-Schaltung und
- der mindestens eine den Verstärkerausgang treibende zweite Transistor (4a-4e)

in einer Emitter- bzw. Source-Schaltung betrieben werden.

3. Mess-Schaltung nach Anspruch 2,
**dadurch gekennzeichnet,**
**dass**

- der Basis-Anschluss bzw. der Gate-Anschluss sowie
- der Emitter-Anschluss bzw. Source-Anschluss

des ersten Transistors (4f) mit dem jeweils entsprechenden Anschluss des den Verstärkerausgang (8) treibenden mindestens einen zweiten Transistors (4a-4e) kurzgeschlossen sind.

4. Mess-Schaltung nach einem der Ansprüche 1 bis 3,
**dadurch gekennzeichnet,**
**dass** der erste Transistor (4f) vom selben Typ wie der mindestens eine den Verstärkerausgang (8) treibende zweite Transistor (4a-4e) ist.

5. Mess-Schaltung nach einem der Ansprüche 1 bis 4,
**dadurch gekennzeichnet,**
**dass** die Mess-Schaltung einen Widerstand (21) umfasst, der den Ausgangsstrom (27) des ersten Transistors (4f) in ein elektrisches Spannungssignal wandelt, wobei insbesondere der Wert des Widerstands (21) geringer als die Ausgangsimpedanz des ersten Transistors (4f) ist.

6. Mess-Schaltung nach einem der vorhergehenden Ansprüche,
**dadurch gekennzeichnet,**
**dass** die für die Ausgangsleistung des Verstärkers charakteristische Größe (26) für

- die ausgangsseitige Anpassung und/oder
- die Ausgangsleistung und/oder
- die Aussteuerung des den Verstärkerausgang (8) treibenden zweiten Transistors (4a-4e)

charakteristisch ist.

7. Mess-Schaltung nach einem der vorhergehenden Ansprüche,
**dadurch gekennzeichnet,**
**dass** die Mess-Schaltung ein zweites Mittel (25), insbesondere einen Hochfrequenz-Detektor, zur Bereitstellung einer für die Aufgangsspannung des Verstärkers (20) charakteristischen elektrischen Größe umfasst.

8. Mess-Schaltung nach Anspruch 1,
**dadurch gekennzeichnet,**
**dass** das Mittel (23) ein Mischer ist.

9. Mess-Schaltung nach Anspruch 6 und Anspruch 7,
**dadurch gekennzeichnet,**
**dass** die Mess-Schaltung ein drittes Mittel zur Bereitstellung einer für die Impedanz am Verstärkerausgang charakteristischen Größe umfasst, wobei das dritte Mittel die Größe in Abhängigkeit

- der für die Ausgangsspannung des Verstärkers (20) charakteristischen elektrischen Größe und
- des Ausgangsstroms (27) des ersten Transistors (4f) oder einer von diesem Ausgangsstrom (27) abhängigen elektrischen Spannung,

bestimmt, insbesondere durch Division der beiden vorstehend genannten elektrischen Größen.

10. Mess-Schaltung nach Anspruch 6 und Anspruch 7,
**dadurch gekennzeichnet ,**
**dass** die Mess-Schaltung ein viertes Mittel zur Bereitstellung einer

- für das Stehwellenverhältnis oder
- für den Reflektionsfaktor

charakteristischen Größe umfasst, wobei das vierte Mittel die Größe in Abhängigkeit

- des Ausgangsstroms (27) des ersten Transistors (4f) oder einer von diesem Ausgangsstrom abhängigen elektrischen Spannung und
- der für die Ausgangsspannung des Verstärkers (20) charakteristischen elektrischen Größe

bestimmt.

11. Mess-Schaltung nach Anspruch 6 und Anspruch 7,
**dadurch gekennzeichnet,**
**dass** die Mess-Schaltung ein fünftes Mittel, insbesondere einen Phasenkomparator (23), zur Bereitstellung einer für die Phasendifferenz zwischen

- dem Ausgangsstrom des ersten Transistors (27) und
- der für die Ausgangsspannung des Verstärkers (20) charakteristischen elektrischen Größe

umfasst.

12. Mess-Schaltung nach einem der Ansprüche 7 bis 11,
**dadurch gekennzeichnet:,**
**dass** die Mess-Schaltung ein sechstes Mittel (25) umfasst, welches in Abhängigkeit der für die Ausgangsspannung des Verstärkers (20) charakteristischen elektrischen Größe angibt, insbesondere durch Vergleich dieser Größe mit der Sättigungsspannung des mindestens einen zweiten Transistors (4a-4e), ob der mindestens eine den Verstärkerausgang (8) treibende zweite Transistor (4a-4e) übersteuert wird.

13. Mess-Schaltung nach einem der Ansprüche 7 bis 12,
**dadurch gekennzeichnet,**
**dass** die Mess-Schaltung ein siebtes Mittel (24) umfasst, welches in Abhängigkeit der für den Ausgangsstrom (28) des Verstärkers (20) charakteristischen elektrischen Größe angibt, insbesondere durch Vergleich dieser Größe mit einem Maximalwert des mindestens einen zweiten Transistors (4a-4e), ob der mindestens eine den Verstärkerausgang (8) treibende zweite Transistor (4a-4e) übersteuert wird.

14. Verstärker (20), mit

- einer Mess-Schaltung nach einem der Ansprüche 1 bis 12 und
- mindestens einem den Verstärkerausgang (8) treibenden zweiten Transistor (4a-4e), wobei der Verstärkerausgang (8) insbesondere ein Open-Collector- bzw. Open-Drain-Verstärkerausgang ist.

15. Verstärker nach Anspruch 14,
**dadurch gekennzeichnet,**
**dass** der Verstärker (20) ein Hochfrequenz-Verstärker, insbesondere ein Hochfrequenz-Leistungsverstärker, ist.

16. Regelkreis zur Regelung einer mit einer Mess-Schaltung nach einem der Ansprüche 1 bis 12 bestimmten Größe eines Verstärkers (20) nach einem der Ansprüche 14 oder 15, **dadurch gekennzeichnet dass** der Regelkreis eine Mess-Schaltung nach einem der Ansprüche 1 bis 12 umfasst.

**17.** Mess-Verfahren für einen Ausgang (8) eines Verstärkers (20), mit den Schritten:

- Ermitteln des Ausgangsstroms (27) eines ersten Transistors (4f), wobei der Ausgangsstrom (27) charakteristisch für den Ausgangsstrom (28) des Verstärkers (20) ist, insbesondere im wesentlichen proportional zum Ausgangsstrom (28) des Verstärkers (20), und der erste Transistor (4f) parallel zu mindestens einem den Verstärkerausgang (8) treibenden zweiten Transistor (4a-4e) angesteuert wird, und
- Bestimmen einer für die Ausgangsleistung des Verstärkers charakteristischen Größe (26) durch eine Multiplikation des Ausgangsstroms (27) des ersten Transistors (4f) oder einer von diesem Ausgangsstrom (27) abhängigen elektrischen Spannung und einer für die Ausgangsspannung des Verstärkers (20) charakteristischen elektrischen Größe.

**18.** Mess-Verfahren nach Anspruch 17,
**gekennzeichnet durch:**

die für die Ausgangleistung des Verstärkers charakteristische Größe (26) für die Funktion mindestens eines den Verstärkerausgang treibenden zweiten Transistors, insbesondere für

- die ausgangsseitige Anpassung und/oder
- die Ausgangsleistung und/oder
- die Aussteuerung des den Verstärkerausgang treibenden zweiten Transistors

charakteristisch ist.

**Claims**

**1.** Measuring circuit for an output (8) of an amplifier (20), having:

- a first transistor (4f), the output current (27) of which is characteristic of the output current (28) of the amplifier (20), in particular essentially proportional to the output current (28) of the amplifier (20), and which is driven in parallel with at least one second transistor (4a-4e) driving the amplifier output (8), and
- a means for providing a variable (26) that is characteristic of the output power of the amplifier,

the means (23) determining the variable that is characteristic of the output power of the amplifier by multiplication of the output current (27) of the first transistor (4f) or an electrical voltage dependent on said output current (27) and an electrical variable characteristic of the output voltage of the amplifier (20).

**2.** Measuring circuit according to Claim 1,
**characterized**
**in that**

- the first transistor (4f) of the measuring circuit and
- the at least one second transistor (4a-4e) driving the amplifier output

are operated in a common-emitter connection or common-source connection.

**3.** Measuring circuit according to Claim 2,
**characterized**
**in that**

- the base terminal or the gate terminal and
- the emitter terminal or source terminal of the first transistor (4f) are short-circuited with the respectively corresponding terminal of the at least one second transistor (4a-4e) driving the amplifier output (8).

**4.** Measuring circuit according to one of Claims 1 to 3,
**characterized**
**in that** the first transistor (4f) is of the same type as the at least one second transistor (4a-4e) driving the amplifier output (8).

**5.** Measuring circuit according to one of Claims 1 to 4,
**characterized**
**in that** the measuring circuit comprises a resistor (21) which converts the output current (27) of the first transistor (4f) into an electrical voltage signal, in particular the value of the resistor (21) being lower than the output impedance of the first transistor (4f).

**6.** Measuring circuit according to one of the preceding claims,
**characterized**
**in that** the variable (26) that is characteristic of the output power of the amplifier is characteristic of

- the matching on the output side and/or
- the output power and/or
- the modulation of the second transistor (4a-4e) driving the amplifier output (8).

**7.** Measuring circuit according to one of the preceding claims,
**characterized**
**in that** the measuring circuit comprises a second means (25), in particular a radio frequency detector, for providing an electrical variable that is characteristic of the output voltage of the amplifier (20).

**8.** Measuring circuit according to Claim 1,
**characterized**
**in that** the means (23) is a mixer.

**9.** Measuring circuit according to Claim 6 and Claim 7,
**characterized**
**in that** the measuring circuit comprises a third means for providing a variable that is characteristic of the impedance at the amplifier output, the third means determining the variable in a manner dependent on

- the electrical variable characteristic of the output voltage of the amplifier (20), and
- the output current (27) of the first transistor (4f) or an electrical voltage dependent on said output current (27),

in particular by division of the two electrical quantities mentioned above.

**10.** Measuring circuit according to Claim 6 and Claim 7,
**characterized**
**in that** the measuring circuit comprises a fourth means for providing a variable that is characteristic

- of the standing wave ratio or
- of the reflection factor

the fourth means determining the variable in a manner dependent on

- the fourth output current (27) of the first transistor (4f) or an electrical voltage dependent on said output current, and
- the electrical variable characteristic of the output voltage of the amplifier (20).

**11.** Measuring circuit according to Claim 6 and Claim 7,
**characterized**
**in that** the measuring circuit comprises a fifth means, in particular a phase comparator (23), for providing an electrical variable that is characteristic of the phase difference between

- the output current of the first transistor (27) and
- the electrical variable characteristic of the output voltage of the amplifier (20).

**12.** Measuring circuit according to one of Claims 7 to 11,
**characterized**
**in that** the measuring circuit comprises a sixth means (25) which indicates, in a manner dependent on the electrical variable characteristic of the output voltage of the amplifier (20), in particular by comparison of the said variable with the saturation voltage of the at least one second transistor (4a-4e), whether the at least one second transistor (4a-4e) driving the amplifier output (8) is overdriven.

13. Measuring circuit according to one of Claims 7 to 12,
    **characterized**
    **in that** the measuring circuit comprises a seventh means (24) which indicates, in a manner dependent on the electrical variable characteristic of the output current (28) of the amplifier (20), in particular by comparison of said variable with a maximum value of the at least one second transistor (4a-4e), whether the at least one second transistor (4a-4e) driving the amplifier output (8) is overdriven.

14. Amplifier (20), having

    - a measuring circuit according to one of Claims 1 to 12 and
    - at least one second transistor (4a-4e) driving the amplifier output (8), the amplifier output (8) being, in particular, an open-collector or open-drain amplifier output.

15. Amplifier according to Claim 14,
    **characterized**
    **in that** the amplifier (20) is a radio frequency amplifier, in particular a radio frequency power amplifier.

16. Regulating circuit for regulating a variable, determined by a measuring circuit according to one of Claims 1 to 12, of an amplifier (20) according to either of Claims 14 and 15, **characterized in that** the circuit regulating comprises a measuring circuit according to one of Claims 1 to 12.

17. Measuring method for an output (8) of an amplifier (20), having the steps:

    - determining the output current (27) of a first transistor (4f), the output current (27) being characteristic of the output current (28) of the amplifier (20), in particular essentially proportional to the output current (28) of the amplifier (20), and the first transistor (4f) being driven in parallel with at least one second transistor (4a-4e) driving the amplifier output (8), and
    - determining a variable (26) that is characteristic of the output power of the amplifier by multiplication of the output current (27) of the first transistor (4f) or an electrical voltage dependent on said output current (27) and an electrical variable characteristic of the output voltage of the amplifier (20).

18. Measuring method according to Claim 17,
    **characterized by**:

    - determining the electrical variable characteristic of the output voltage of the amplifier (20);

    the variable (26) that is characteristic of the output power of the amplifier being characteristic of the function of at least one second transistor driving the amplifier output, in particular of

    - the matching on the output side and/or
    - the output power and/or
    - the modulation of the second transistor driving the amplifier output.

**Revendications**

1. Circuit de mesure pour une sortie (8) d'un amplificateur (20), comprenant :

    - un premier transistor (4f), dont le courant (27) de sortie est caractéristique du courant (28) de sortie de l'amplificateur, en étant sensiblement proportionnel au courant (28) de sortie de l'amplificateur (20), et qui est commandé en parallèle à au moins un deuxième transistor (4a à 4e) attaquant la sortie (8) de l'amplificateur, et
    - un moyen pour la mise à disposition d'une grandeur (26) caractéristique de la puissance de sortie de l'amplificateur,

    dans lequel le moyen (23) détermine la grandeur caractéristique de la puissance de sortie de l'amplificateur par une multiplication du courant (27) de sortie du premier transistor (4f) ou d'une tension électrique qui dépend de ce courant (27) de sortie et d'une grandeur électrique caractéristique de la tension de sortie de l'amplificateur (20).

2.  Circuit de mesure suivant la revendication 1,
    **caractérisé
    en ce que**

    - le premier transistor (4f) du circuit de mesure et
    - le au moins un deuxième transistor (4a à 4e) attaquant la sortie de l'amplificateur

    sont montés en un circuit émetteur ou en un circuit source.

3.  Circuit de mesure suivant la revendication 2,
    **caractérisé
    en ce que**

    - la borne de base ou la borne de grille ainsi que
    - la borne d'émetteur ou la borne de source

    du premier transistor (4f) sont court-circuitées avec la borne correspondante respectivement du au moins un deuxième transistor (4a à 4e) attaquant la sortie (8) de l'amplificateur.

4.  Circuit de mesure suivant l'une des revendications 1 à 3,
    **caractérisé
    en ce que** le premier transistor (4f) est du même type que le au moins un deuxième transistor (4a à 4e) attaquant la sortie (8) de l'amplificateur.

5.  Circuit de mesure suivant l'une des revendications 1 à 4,
    **caractérisé
    en ce que** le circuit de mesure comprend une résistance (21), qui transforme le courant (27) de sortie du premier transistor (4f) en un signal de tension électrique, dans lequel notamment la valeur de la résistance (21) est plus petite que l'impédance de sortie du premier transistor (4f).

6.  Circuit de mesure suivant l'une des revendications précédentes,
    **caractérisé
    en ce que** la grandeur (26) caractéristique de la puissance de sortie de l'amplificateur est caractéristique de

    - l'adaptation côté sortie et/ou
    - la puissance de sortie et/ou
    - l'attaque du deuxième transistor (4a à 4$^e$) attaquant la sortie (8) de l'amplificateur.

7.  Circuit de mesure suivant l'une des revendications précédentes,
    **caractérisé
    en ce que** le circuit de mesure comprend un deuxième moyen (25), notamment un détecteur de haute fréquence, pour la mise à disposition d'une grandeur électrique caractéristique de la tension de sortie de l'amplificateur (20).

8.  Circuit de mesure suivant la revendication 1,
    **caractérisé
    en ce que** le moyen (23) est un mélangeur.

9.  Circuit de mesure suivant la revendication 6 et la revendication 7,
    **caractérisé
    en ce que** le circuit de mesure comprend un troisième moyen pour la mise à disposition d'une grandeur caractéristique de l'impédance à la sortie de l'amplificateur, le troisième moyen définissant la grandeur en fonction

    - de la grandeur électrique caractéristique de la tension de sortie de l'amplificateur (20) et
    - du courant (27) de sortie du premier transistor (4f) ou d'une tension électrique dépendant de ce courant (27) de sortie,

notamment par division des deux grandeurs électriques mentionnées précédemment.

10. Circuit de mesure suivant la revendication 6 et la revendication 7, **caractérisé**
    **en ce que** le circuit de mesure comprend un quatrième moyen pour la mise à disposition d'une grandeur caractéristique

    - du taux d'ondulation ou
    - du facteur de réflexion

    dans lequel le quatrième moyen détermine la grandeur en fonction

    - du courant (27) de sortie du premier transistor (4f) ou d'une tension électrique dépendant de ce courant de sortie et
    - de la grandeur électrique caractéristique de la tension de sortie de l'amplificateur (20).

11. Circuit de mesure suivant la revendication 6 et la revendication 7, **caractérisé**
    **en ce que** le circuit de mesure comprend un cinquième moyen, notamment un comparateur (23) de phase, pour la mise à disposition d'une différence de phase entre

    - le courant de sortie du premier transistor (27) et
    - la grandeur électrique caractéristique de la tension de sortie de l'amplificateur.

12. Circuit de mesure suivant l'une des revendications 7 à 11, **caractérisé**
    **en ce que** le circuit de mesure comprend un sixième moyen (25), qui indique, en fonction de la grandeur électrique caractéristique de la tension de sortie de l'amplificateur (20), notamment en comparant cette grandeur à la tension de saturation du au moins un deuxième transistor (4a à 4e), si le au moins un deuxième transistor (4a à 4e) attaquant la sortie (8) de l'amplificateur est sursaturé.

13. Circuit de mesure suivant l'une des revendications 7 à 12, **caractérisé**
    **en ce que** le circuit de mesure comprend un septième moyen (24), qui indique, en fonction de la grandeur électrique caractéristique du courant (28) de sortie de l'amplificateur (20), notamment en comparant cette grandeur à une valeur maximum du au moins un deuxième transistor (4a à 4e), si le au moins un deuxième transistor (4a à 4e) attaquant la sortie (8) de l'amplificateur est sursaturé.

14. Amplificateur (20), comprenant

    - un circuit de mesure suivant l'une des revendications 1 à 12 et
    - au moins un deuxième transistor (4a à 4e) attaquant la sortie (8) de l'amplificateur, la sortie (8) de l'amplificateur étant notamment une sortie d'amplificateur open-collector ou open-drain.

15. Amplificateur suivant la revendication 14, **caractérisé**
    **en ce que** l'amplificateur (20) est un amplificateur de haute fréquence, notamment un amplificateur de puissance de haute fréquence.

16. Circuit de régulation pour la régulation d'une grandeur déterminée par un circuit de mesure suivant l'une des revendications 1 à 12, d'un amplificateur (20) suivant l'une des revendications 4 ou 5, **caractérisé en ce que** le circuit de régulation comprend un circuit de mesure suivant l'une des revendications 1 à 12.

17. Procédé de mesure pour une sortie (8) d'un amplificateur (20), comprenant les stades dans lesquels :

    - on détermine le courant (27) de sortie d'un premier transistor (4f), le courant (27) de sortie étant caractéristique du courant (28) de sortie de l'amplificateur (20), en étant notamment sensiblement proportionnel au courant (28) de sortie de l'amplificateur (20), et le premier transistor (4f) étant commandé en parallèle à au moins un deuxième transistor (4a à 4e) attaquant la sortie (8) de l'amplificateur, et

- on définit une grandeur (26) caractéristique de la puissance de sortie de l'amplificateur par une multiplication du courant (27) de sortie du premier transistor (4f) ou d'une tension électrique dépendant de ce courant (27) de sortie et d'une grandeur électrique caractéristique de la tension de sortie de l'amplificateur (20).

**18.** Procédé de mesure suivant la revendication 17,
   **caractérisé en ce que** :

   on détermine la grandeur électrique caractéristique de la tension de sortie de l'amplificateur, dans lequel

   pour la puissance de sortie de l'amplificateur, la grandeur (26) caractéristique est caractéristique de la fonction d'au moins un deuxième transistor attaquant la sortie de l'amplificateur, notamment de

   - l'adaptation côté sortie et/ou
   - la puissance de sortie et/ou
   - l'attaque du deuxième transistor attaquant la sortie de l'amplificateur.

# FIG 1

# FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020118034 A1
- WO 9614665 A
- US 5546050 A
- US 6424191 B1